# EUROPEAN PATENT SPECIFICATION

(11) **EP 0 739 816 B1**
(45) Date of publication and mention of the grant of the patent: **28.02.2001**
(21) Application number: 96106450.8
(22) Date of filing: 24.04.1996
(51) Int. Cl.: B64D 11/00, H03J 9/06

(54) **Passenger control unit with security control**
Fahrgast-Bedienungseinheit mit einer Sicherheits-Steuerungsvorrichtung
Unité de commande pour passager comportant un dispositif de commande de sécurité

(30) Priority: 26.04.1995 US 430006
(43) Date of publication of application: 30.10.1996
(73) Proprietor: HUGHES-AVICOM INTERNATIONAL, Inc., Los Angeles, CA 90080-0028 (US)
(72) Inventor: Bertagna, Richard A., San Dimas, California 91773 (US); Berry, Dickey J., La Verne, Ca 91750 (US)
(74) Representative: Winter, Brandl, Fürniss, Hübner, Röss, Kaiser, Polte Partnerschaft

(56) References cited:
- WO-A-90/15508
- DE-A- 3 242 978
- US-A- 5 316 249

## Description

### BACKGROUND OF THE INVENTION

### 1. Field of the Invention

The present invention relates to multiple passenger vehicle entertainment systems, and more particularly concerns an improved passenger control unit for communication with an individual passenger audio or video apparatus.

### 2. Description of Related Art

Passenger entertainment systems in multi-passenger vehicles, such as commercial aircraft for example, have included a set of passenger operated control buttons mounted to the side of an armrest of the passenger seat, allowing the individual passenger to control and select a number of different audio channels. More recently, in addition to audio channels, individual video displays have been provided in the back of the passenger seat for visual access by a passenger sitting in the seat immediately behind the seat in which the video display is mounted. In some instances control of the video display is still provided by control buttons that are mounted on the side of the passenger armrest. These control buttons include general service buttons to allow the passenger to call an attendant, to operate individual overhead lights, and also include buttons to select audio or video channels and to control audio volume, among other functions that may be available. The location of the control buttons on the side of the armrest is inconvenient and difficult for the passenger to see and operate. However, the control buttons cannot be placed on the upper side of the armrest, where they would be most conveniently available, because of servicing problems and the possibility of spilling liquids.

One concept for a removable passenger control unit is described in a co-pending application for CORD RETRACTOR MECHANISM, Serial No. 08/156,161, filed November 23, 1993 (PD-A93003, attorney's docket 96-205) invented by Richard A. Bertagna and Dwight G. Westover corresponding to the US patent publication US-A-5 421 530 and assigned to the assignee of the present application. This disclosure of this prior application is incorporated by this reference as though set forth fully herein. In the prior application of Bertagna and Westover a removable hand-held passenger control unit is connected to the seat structure by means of an electrical cable that sends signals from the hand-held control unit, through the passenger seat, and then down to and beneath the floor and up through the seat to the display device on the seat ahead. Similarly, telephone handsets mounted in the seat structure are connected by a retractable electric signal carrying cable. The retractable electrical cable also performs an auxiliary function of providing security for the removable control unit or phone handset because it ensures that the control unit or handset will not inadvertently be removed from the seat area. The cord or cable retractor is subject to wear and related problems that are due, in part, to the repetitive flexing, bending, pulling and folding of the electric cable as it moves between extended and retracted positions. A retractable, foldable or wind-up electric cable can be subject to damage to the various electrical connections at the cable ends, and the extended cable itself is also susceptible to inadvertent damage.

WO-A-90/15508 discloses a vehicle passenger communication system according to the preamble of claim 1.

Accordingly, it is an object of the present invention to provide a passenger control unit and a vehicle passenger communication system that avoids or minimizes above mentioned problems.

### SUMMARY OF THE INVENTION

This object of the present invention is solved by a vehicle passenger communication system according to claim 1.

In carrying out principles of the present invention in accordance with a preferred embodiment thereof, a seat electronics box configured and arranged to receive signals from a remote source is coupled to an output device, such as a video display or a phone unit, that includes an infrared receiver. A passenger control unit that is removably mounted to the seat structure is arranged to send infrared signals to the infrared receiver for use by the output device, and security means are provided to assure that the passenger control unit is returned to its proper place in the passenger seat structure. The security means may take one of several different forms, such as an electric or similar sensor that detects and remotely signals the mounting of the control unit in the passenger seat, a battery charging circuit that charges a battery in the control unit only when the latter is installed in its proper position in the seat, with remote indication of proper operation of the battery charging, or a simple non-electrical string or line that physically limits removal of the control unit beyond a selected distance.

The use of infrared transmission, at least from the hand-held control unit to the video display, or both to and from a hand-held telephone handset and a phone unit in the seat back, provides for the maximum flexibility and convenience of use of the handset by the passenger, whereas the security device protects against loss or theft of the relatively expensive control unit with its battery, transmitter and/or transmitters and receivers. Where an electrical or equivalent security sensor is used, the passenger control unit is completely free of and unattached to the seat structure, thereby providing optimum convenience without compromising security.

As one type of electronic security, an installation recess provided in the passenger seat armrest may include a set of electrical contacts which electrically and physically engage a corresponding set of electrical contacts on an outer surface of the removable hand-held unit when the latter is properly returned to its installed position within the armrest recess. This not only provides for charging of the battery of the hand-held unit but, by virtue of remote monitoring of the flow of charging current, also provides a remote indication of the proper reinstallation of the hand-held unit in the passenger seat armrest.

### BRIEF DESCRIPTION OF THE DRAWINGS

In the accompanying drawings:
FIG. 1 shows a pair of passenger seats of a multi-passenger vehicle, illustrating one possible relation of the various elements and showing the use of a hand-held control unit for controlling the display of a video screen;
FIG. 2 illustrates a passenger seat armrest with a detachable control unit installed in the armrest; and
FIG. 3 is a perspective view showing a general relation of the passenger seat armrest, the detached hand-held control unit and the seat electronics box, together with its video display device.

### DESCRIPTION OF THE PREFERRED EMBODIMENTS

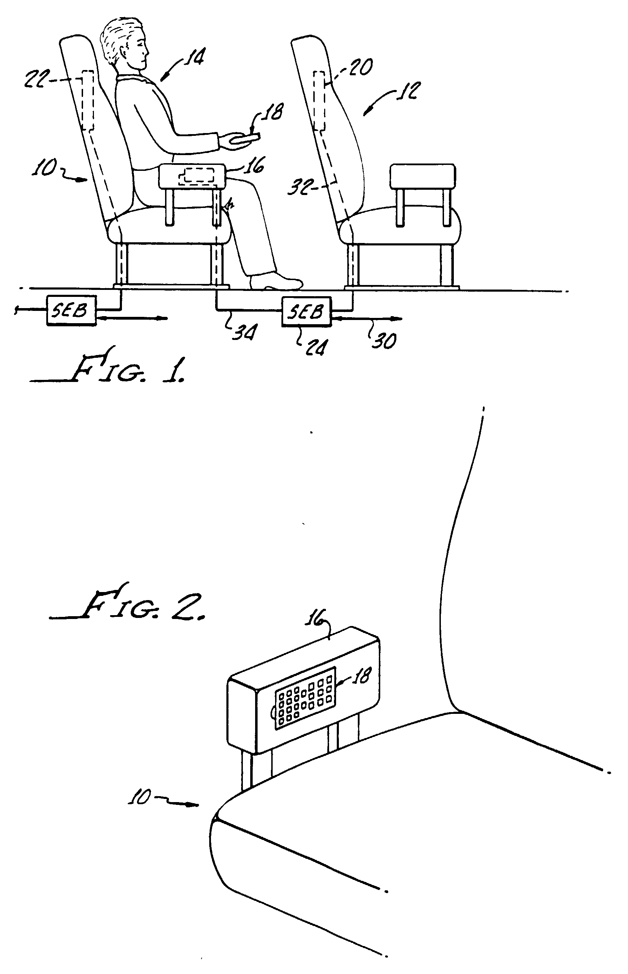

Illustrated in FIG. 1 is a pair of in-line seats 10 and 12 of a multi-passenger vehicle, such as an airplane, with the first seat 10 having a passenger 14 seated in a seat structure that includes an armrest 16. The passenger holds in his hand a control unit 18 that controls a video display device 20 that is mounted in the back of the forward seat 12 and which display device is visually accessible to the passenger 14 in the rearward seat 10. The seats shown are merely illustrative of two adjacent seats of a common arrangement of seats of a multi-seat vehicle. Various types of signals, audio and video channels, information signals, and the like, are distributed to each of the passenger seats, which may be as many as 300 or more in number in a given vehicle, in a manner such as described in a U. S. Patent for AUTOMATIC RF EQUALIZATION IN PASSENGER AIRCRAFT VIDEO DISTRIBUTION SYSTEM of Irving Rabowsky and Richard E. Sklar, U. S. Patent No. 5,214,505 on May 25, 1993. As described in detail in the this patent, the distribution system includes generally centralized remote sources of audio and video inputs distributed by electrical cables passing under the floor of the aircraft to individual seats of the vehicle. Each seat includes a video display device, such as display device 20 in the back of forward seat 12, and a comparable display device 22 in the back of rearward seat 10. Display device 22, of course, is for use by a passenger in a seat (not shown) positioned behind rearward seat 10. Electrical signals are distributed by cable to individual video displays via a seat electronics box (SEB) 24 that is individual to each particular seat (or to a group of seats). Preferably there is one of these seat electronics boxes for each seat. The seat electronics box includes suitable electronics, including a substantially conventional programmed microprocessor for selecting signals from a transmitting cable 30, and sending these signals by wire, together with appropriate electrical power, to the passenger control unit in seat 10 and to the video display device in seat 12. Various signals are transmitted from a remote source 36 along electric cable 30 to the seat electronics box 24, which in turn may transmit certain signals back along cable 30 to the same or some additional remote source, as will be described below. The seat electronics box may be a separate box connected by a cable 32 to the display device 20 and via a cable 34 to the passenger seat structure, such as to the armrest 16 and thence to the control unit 18 (when the latter is properly installed in its seat structure location, armrest 16, as will be described below). The seat electronics boxes 24 may be suitably located as considered most convenient. They may be mounted under the floor of the vehicle passenger compartment, as illustrated in FIG. 1, or some or all of their electronics circuitry may be combined with the video screen 20 and mounted in the display device that is secured to the back of the seat 12.

Control unit 18 is detachably and removably connected to the seat structure 10, preferably in a recess within armrest 16, as will be described below, and contains a plurality of control buttons for control of various service functions and control of the display device. Thus the passenger, by operating the various control buttons of the control unit, may select audio or video channels, may play a video game in which various symbols are controlled and moved over the screen by appropriate control buttons or the like on the control unit, or may summon a flight attendant, operate seat lights or perform other functions normally available to a passenger.

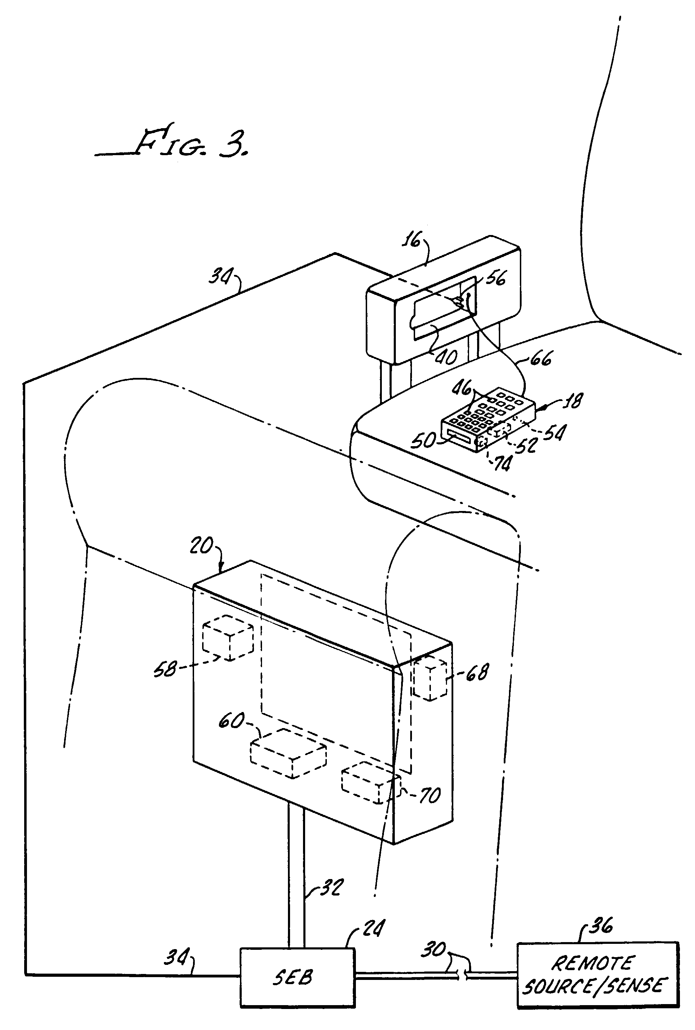

The control unit 18 is mounted in a recess 40 (FIG. 3) formed in the side of the seat armrest 16. FIG. 2 illustrates the control unit properly installed in the armrest recess from which it may be readily removed by the passenger for control of the display, playing video games or the like.

FIG. 3 illustrates the control unit 18 completely removed from the recess 40 in armrest 16 for use in controlling the video display device 20. Seat electronics box 24, as previously mentioned, may either be installed beneath the floor under the seat and connected to the display device by means of a cable 32, or may be made part of the display device and installed together with the display device in the seat back.

Passenger control unit 18 includes a plurality of operating buttons collectively indicated at 46 and an infrared transmitter 50 that sends out infrared signals of varying types and bearing selected control information according to control signals produced by operation of the different ones of buttons 46. Also included in the control unit 18 is a battery 52 connected to operate various circuits, including the transmitter 50 of the control unit. Battery 52 is connected to a set of contacts 54 formed at one side on the exterior of the control unit. Electrical contacts 54 are arranged on the outside surface of the control unit so that when the control unit is reinstalled in the recess 40 of the armrest in the position and orientation shown in FIG. 2 contacts 54 will electrically engage a set of contacts 56 that are formed in one wall of the recess 40 that receives the reinstalled passenger control unit. Recess contacts 56 are connected by electrical cable 34 through either a junction box or to the seat electronics box 24, which in turn is connected via cable 30 to remote source 36 which may also include audio and video signal sources, power sources, and remote security sensor. Input cable 30 includes electrical lines that send the various signals from the remote sources and, via the seat electronics box, to the video display 20 (audio and video channels, for example) and also sends power via cable 34 for charging battery 52 when the control unit is installed in the seat recess. An appropriate battery charger 58 may be mounted in the armrest 16 or in a remote location for sending battery charging current to the passenger control unit via seat contacts 56 and control unit contacts 54.

Electronic display device 20 includes an infrared receiver 60 that receives infrared signals transmitted by the hand-held control unit transmitter 50 and utilizes these signals for control of the display device or for operation of a video game or other passenger controllable video screen display.

Because the control unit is removable and is effectively self-contained, being powered by its battery 52, it requires no connection whatsoever to the seat structure or armrest. However, it is possible that the passenger may forget to reinstall the control unit into the recess 40 after use has been completed, or for other reasons may fail to replace the control unit. The control unit with its physical structure and relatively complex electronics is a costly item, and steps must be taken to prevent the loss of such control units because of the cost to the vehicle operator and also because of the inconvenience to subsequent passengers. Accordingly, security is provided to remotely signal the proper reinstallation of the passenger control unit. Preferably security is provided in the form of an electrical sensor to detect proper reinstallation of the control unit. Such a sensor may take many different forms. In the illustrated arrangement the battery charger and its contacts 54,56 provide such remote sensing in that the battery charger 58 begins to operate whenever the passenger control unit is properly reinstalled in the armrest recess and the control units electrically engage the armrest or recess contacts 56.

When and only when the passenger control unit is properly reinstalled in the armrest recess, contacts 54 and 56 are engaged and charging of the battery 52 commences. Charging current is applied from remote source 36 via the SEB 24 and along cable 34. Occurrence of the flow of such charging current may be monitored at remote source 36 to indicate that the battery is charging, and, therefore, that the passenger control unit has been properly reinstalled. For example, upon completion of a flight, just before landing, the entertainment system is shut off and passengers are requested, via the aircraft public address system, to return the control units to the armrest recesses. At that time the charging current to batteries of all the passenger control units may be monitored by the aircraft crew. The flight attendant may approach each passenger whose control unit is not properly installed and to assist with reinstallation. Alternatively, an audible or visual announcement may be made at the individual seat in which reinstallation has not been accomplished in order to remind the passenger of the need to replace the control unit.

Alternate forms of the reinstallation sensor, shown in FIG. 3 as including the battery charging electrical contacts 54,56, may be simply take the form of a micro-switch that is actuated upon proper reinstallation to close a circuit that provides an appropriate signal to a remote location. In some situations it may be found desirable to add a backup security system in the form of a tether 66 (FIG. 3), which is not an electrical cable and carries no electrical signals, but is merely a line or string that prevents complete removal of the passenger control unit from the general vicinity of the passenger seat. Preferably, the physical tether is omitted and only an electrical security sensor is used.

Where telephone communication is desired, the passenger control unit 18 will include a substantially conventional telephone handset forming part of the passenger control unit and including both hearing and speaking microphones as in a conventional telephone handset. In such a system the seat electronics box or its incorporated display device 20 will include not only the infrared receiver 60 but an infrared transmitter 68 that is connected to a phone unit 70, which in turn, connects, via the electronics of the seat electronics box 24, to a phone line that is included in the input cable 30. Thus, voice signals are transmitted from a remote location electrically along cable 30 and via the seat electronics box 24 to the infrared transmitter 68 of the seat electronics box. The transmitter 68 transmits the incoming voice signals via infrared transmission to an infrared receiver 74 in the passenger control unit 18. Receiver 74 converts infrared signals to electrical signals and sends the received voice signals to the receiving transducer of the control unit for changing the electrical voice signals to audible sound. Similarly, a passenger who speaks into the hand-held control unit mouthpiece has his voice signals communicated to the infrared transmitter 50, which sends these voice signals by infrared transmission to infrared receiver 60 of the seat electronics box for changing these signals to electrical signals that are fed via the seat electronics box and cable 30 to a remote location.

It will be readily understood that only where two-way communication between the passenger control unit 18 and device 20 of the seat electronics box 24 is desired, is it necessary to mount both infrared transmitters and receivers in both the control unit and the seat electronics box (or display device). Where the passenger entertainment system does not have a telephone capability it is not necessary to provide any communication from the video display portion of the seat electronics box/display combination (except for the electrical power and monitoring signals fed along electrical cable 34 from the seat electronics box to the armrest). In such a case, without telephone capability, passenger control unit 18 includes only the infrared transmitter 50 and seat electronics box 24 and its display device 20 mount only an infrared receiver, since no information other than visual information is transmitted from the video display device to the passenger.

It will be seen that there have been described methods and apparatus for a vehicle passenger communication system embodying a completely free and detached or a substantially free and detached passenger control unit that enables remote passenger control of the display device on the back of the seat ahead of him or in some other adjacent location while maintaining adequate security to minimize the possibility of loss or theft of the detached control unit. Security may be provided either by a suitable electrical sensor which detects and remotely signals proper reinstallation of the control unit in the seat structure. Such security may be backed up by an ordinary non-electrical restraining tether that is provided in addition to the electrical sensing and signalling contacts. As an additional or alternate arrangement, the passenger seat control unit may provide for telephone communication utilizing two-way infrared transmission between the hand-held passenger control unit and a phone unit in the nearby seat electronics box, again with security provided by a suitable electrical sensor. In one embodiment the electrical sensor takes the form of sets of electrical contacts in a recess in the armrest that receives the reinstalled passenger control unit and a mating and engaging set of electrical contacts on the passenger control unit which send battery charging current to a recharge a battery mounted in the passenger control unit.

## Claims

1. A vehicle passenger communication system comprising:
a passenger seat structure (10),
a seat electronics box (24) that is configured and arranged to receive signals from a remote source (36), said seat electronics box including an output device (20), and
a passenger control unit (18),
characterized in that
said seat electronics box (24) further includes an infrared receiver (60) and that said output device (20) is coupled to said receiver (60),
said passenger control unit (18) is removably mounted in a predetermined position to said seat structure (10) for sending infrared signals to said seat electronics box receiver (60),
and characterized in that the system further comprises
an electrical security sensor (54, 56) configured and arranged to signal when said removable passenger control unit (18) is in said predetermined position.

2. The vehicle passenger communication system of Claim 1 wherein said security sensor comprises an electrical sensor (54,56) in said seat structure that is activated by mounting of said passenger control unit to said seat structure.

3. The vehicle passenger communication system of Claim 1 wherein said security sensor comprises a cable (32) for sending seat electronics box signals to said passenger control unit from said seat electronics box.

4. The vehicle passenger communication system of Claim 3 wherein said means for sending seat electronics box signals comprises mutually engageable and disengageable electrical contacts (54,56) on said passenger control unit and said seat structure configured and arranged to transmit electrical signals between said passenger control unit and said seat structure.

5. The vehicle passenger communication system of Claim 1 wherein said security sensor comprises mutually detachable and mutually engageable electrical contacts (54,56) on said seat structure and said control unit configured and arranged to transmit an electrical signal between said seat structure and said control unit when said control unit occupies said predetermined positional relation relative to said seat structure.

6. The vehicle passenger communication system of any one of Claims 1, 3 and 4 wherein said security sensor additionally includes a physical tether (66).

7. The vehicle passenger communication system of Claim 1 wherein said security sensor comprises an electrical sensor for remotely signalling the mounting of said passenger control unit to said seat structure.

8. The vehicle passenger communication system of Claim 1 wherein said seat electronics box includes a video screen (20) for providing a controllable display, and wherein said passenger control unit includes control elements (46) for controlling said display on said video screen.

9. The vehicle passenger communication system of Claim 1 wherein said passenger control unit comprises a hand-held telephone set (18), and wherein said seat electronics box includes a telephone unit (70) for receiving and transmitting audio signals from and to a remote location, said seat electronics box including an infrared transmitter (68) for transmitting audio signals to said passenger control unit from said seat electronics box telephone unit, and wherein said passenger control unit includes an infrared receiver (74) for receiving infrared signals transmitted from said telephone unit (70).

10. The vehicle passenger communication system of Claim 1 wherein said passenger control unit includes a battery (52), said seat electronics box including a battery charger (58), said security sensor including a set of seat electrical contacts (56) in said seat structure connected to said battery charger, set of control unit electrical contacts (54) on said control unit connected to said battery and configured and arranged to physically and electrically engage said set of seat electrical contacts when said passenger control unit has at least a portion thereof in physical contact with a portion of said seat structure.

## Patentansprüche

1. Ein Kommunikationssystem für Passagiere in einem Beförderungsmittel mit:
einer Passagiersitzstruktur (10),
einem Elektronikkästchen (24) für den Sitz, das so gestaltet und angeordnet ist, daß es Signale von einer entfernten Quelle (36) empfängt, wobei das Elektronikkästchen für den Sitz eine Ausgabevorrichtung (20) umfaßt, und
einer Passagiersteuereinheit (18),
dadurch gekennzeichnet, daß
das Elektronikkästchen (24) für den Sitz des weiteren einen Infrarotempfänger (60) umfaßt, und daß die Ausgabevorrichtung (20) mit dem Empfänger (60) gekoppelt ist,
die Passagiersteuereinheit (18) wegnehmbar in einer vorbestimmten Position zu der Sitzstruktur (10) zum Senden von Infrarotsignalen zu dem Empfänger (60) des Elektronikkästchens für den Sitz angebracht ist,
und dadurch gekennzeichnet, daß das System des weiteren einen elektrischen Sicherheitssensor (54, 56) aufweist, der so gestaltet und angeordnet ist, daß er signalisiert, wenn die wegnehmbare Passagiersteuereinheit (18) in der vorbestimmten Position ist.

2. Das Kommunikationssystem für Passagiere in einem Beförderungsmittel nach Anspruch 1, dadurch gekennzeichnet, daß der Sicherheitssensor einen elektrischen Sensor (54, 56) in der Sitzstruktur aufweist, der durch das Anbringen der Passagiersteuereinheit an der Sitzstruktur aktiviert wird.

3. Das Kommunikationssystem für Passagiere in einem Beförderungsmittel nach Anspruch 1, dadurch gekennzeichnet, daß der Sicherheitssensor ein Kabel (32) zum Senden der Signale des Elektronikkästchens für den Sitz zu der Passagiersteuereinheit von dem Elektronikkästchen für den Sitz aufweist.

4. Das Kommunikationssystem für Passagiere in einem Beförderungsmittel nach Anspruch 3, dadurch gekennzeichnet, daß die Einrichtung zum Senden der Signale des Elektronikkästchens für den Sitz wechselseitig einkuppelbare und lösbare elektrische Kontakte (54, 56) an der Passagiersteuereinheit und der Sitzstruktur aufweist, die so gestaltet und angeordnet sind, daß sie elektrische Signale zwischen der Passagiersteuereinheit und der Sitzstruktur übertragen.

5. Das Kommunikationssystem für Passagiere in einem Beförderungsmittel nach Anspruch 1, dadurch gekennzeichnet, daß der Sicherheitssensor wechselseitig abnehmbare und wechselseitig einkuppelbare elektrische Kontakte (54, 56) an der Sitzstruktur und der Steuereinheit aufweist, die so gestaltet und angeordnet sind, daß sie ein elektrisches Signal zwischen der Sitzstruktur und der Steuereinheit übertragen, wenn die Steuereinheit die vorbestimmte Positionsbeziehung relativ in Bezug auf die Sitzstruktur einnimmt.

6. Das Kommunikationssystem für Passagiere in einem Beförderungsmittel nach irgendeinem der Ansprüche 1, 3 und 4, dadurch gekennzeichnet, daß der Sicherheitssensor zusätzlich einen physischen Haltestrick (66) umfaßt.

7. Das Kommunikationssystem für Passagiere in einem Beförderungsmittel nach Anspruch 1, dadurch gekennzeichnet, daß der Sicherheitssensor einen elektrischen Sensor zum Fernsignalisieren des Anbringens der Passagiersteuereinheit an der Sitzstruktur aufweist.

8. Das Kommunikationssystem für Passagiere in einem Beförderungsmittel nach Anspruch 1, dadurch gekennzeichnet, daß das Elektronikkästchen für den Sitz einen Bildschirm (20) zum Bereitstellen einer steuerbaren Anzeige umfaßt, und dadurch gekennzeichnet, daß die Passagiersteuereinheit Steuerelemente (46) zum Steuern der Anzeige auf dem Bildschirm umfaßt.

9. Das Kommunikationssystem für Passagiere in einem Beförderungsmittel nach Anspruch 1, dadurch gekennzeichnet, daß die Passagiersteuereinheit ein in der Hand zu haltenes Telefongerät (18) aufweist, und dadurch gekennzeichnet, daß das Elektronikkästchen für den Sitz eine Telefoneinheit (70) zum Empfangen und Übertragen von Audiosignalen von und zu einem entfernten Platz umfaßt, wobei das Elektronikkästchen für den Sitz einen Infrarotsender (68) zum Übertragen von Audiosignalen zu der Passagiersteuereinheit von der Telefoneinheit des Elektronikkästchens für den Sitz umfaßt, und dadurch, daß die Passagiersteuereinheit einen Infrarotempfänger (74) zum Empfangen der von der Telefoneinheit (70) übertragenen Infrarotsignale umfaßt.

10. Das Kommunikationssystem für Passagiere in einem Beförderungsmittel nach Anspruch 1, dadurch gekennzeichnet, daß die Passagiersteuereinheit eine Batterie (52) umfaßt, wobei das Elektronikkästchen für den Sitz ein Batterieladegerät (58) umfaßt, wobei der Sicherheitssensor einen Satz von elektrischen Sitzkontakten (56) in der Sitzstruktur, die mit dem Batterieladegerät verbunden sind, und einen Satz von elektrischen Steuereinheitkontakten (54) an der Steuereinheit, die mit der Batterie verbunden sind, umfaßt, so gestaltet und angeordnet, daß sie physisch und elektrisch mit dem Satz von elektrischen Sitzkontakten in Eingriff stehen, wenn wenigstens ein Teil der Passagiersteuereinheit in physischem Kontakt mit einem Teil der Sitzstruktur steht.

## Revendications

1. Système de communication de passager de véhicule comportant :
une structure de siège de passager (10),
une boîte électronique de siège (24) qui est configurée et agencée pour recevoir des signaux provenant d'une source à distance (36), ladite boîte électronique de siège comprenant un dispositif de sortie (20), et
une unité de commande de passager (18),
caractérisé en ce que
ladite boîte électronique de siège (24) comprend en outre un récepteur infrarouge (60) et en ce que ledit dispositif de sortie (20) est relié audit récepteur (60),
ladite unité de commande de passager (18) est montée de façon amovible dans une position prédéterminée sur ladite structure de siège (10) afin d'envoyer des signaux infrarouges audit récepteur de boîte électronique de siège (60),
et caractérisé en ce que le système comprend en outre
un capteur de sécurité électrique (54, 56) configuré et agencé afin de signaler quand ladite unité de commande de passager amovible (18) est dans ladite position prédéterminée.

2. Système de communication de passager de véhicule selon la revendication 1, dans lequel ledit capteur de sécurité comprend un capteur électrique (54, 56) dans ladite structure de siège qui est activé en montant ladite unité de commande de passager sur ladite structure de siège.

3. Système de communication de passager de véhicule selon la revendication 1, dans lequel ledit capteur de sécurité comprend un câble (32) destiné à envoyer des signaux de boîte électronique de siège vers ladite unité de commande de passager à partir de ladite boîte électronique de siège.

4. Système de communication de passager de véhicule selon la revendication 3, dans lequel lesdits moyens destinés à envoyer des signaux de boîte électronique de siège comportent des contacts électriques pouvant être mutuellement engagés et désengagés (54, 56) sur ladite unité de commande de passager et ladite structure de siège configurés et agencés pour transmettre des signaux électriques entre ladite unité de commande de passager et ladite structure de siège.

5. Système de communication de passager de véhicule selon la revendication 1, dans lequel ledit capteur de sécurité comprend des contacts électriques pouvant être mutuellement engagés et mutuellement désengagés (54, 56) sur ladite structure de siège et ladite unité de commande configurés et agencés pour transmettre un signal électrique entre ladite structure de siège et ladite unité de commande lorsque ladite unité de commande occupe ladite relation de position prédéterminée par rapport à ladite structure de siège.

6. Système de communication de passager de véhicule selon l'une quelconque des revendications 1, 3 et 4, dans lequel ledit capteur de sécurité comprend une sangle physique (66).

7. Système de communication de passager de véhicule selon la revendication 1, dans lequel ledit capteur de sécurité comprend un capteur électrique destiné à signaler à distance le montage de ladite unité de commande de passager sur ladite structure de siège.

8. Système de communication de passager de véhicule selon la revendication 1, dans lequel ladite boîte électronique de siège comprend un écran vidéo (20) destiné à procurer un affichage pouvant être commandé, et dans lequel ladite unité de commande de passager comprend des éléments de commande (46) destinés à commander ledit affichage sur ledit écran vidéo.

9. Système de communication de passager de véhicule selon la revendication 1, dans lequel ladite unité de commande de passager comporte un ensemble de téléphone portatif (18), et dans lequel ladite boîte électronique de siège comprend une unité de téléphone (70) destinée à recevoir et transmettre des signaux audio depuis et vers un emplacement à distance, ladite boîte électronique de siège comprenant un émetteur infrarouge (68) destiné à transmettre des signaux audio vers ladite unité de commande de passager depuis ladite unité de téléphone de boîte électronique de siège, et dans lequel ladite unité de commande de passager comprend un récepteur infrarouge (74) destiné à recevoir des signaux infrarouges transmis depuis ladite unité de téléphone (70).

10. Système de communication de passager de véhicule selon la revendication 1, dans lequel ladite unité de commande de passager comprend une batterie (52), ladite boîte électronique de siège comprenant un chargeur de batterie (58), ledit capteur de sécurité comprenant un ensemble de contacts électriques de siège (56) dans ladite structure de siège reliés audit chargeur de batterie, un ensemble de contacts électriques d'unité de commande (54) sur ladite unité de commande reliés à ladite batterie et configurés et agencés afin d'engager physiquement et électriquement ledit ensemble de contacts électriques de siège lorsque ladite unité de commande de passager a au moins une partie de celle-ci en contact physique avec une partie de ladite structure de siège.
